Europäisches Patentamt

European Patent Office

Office européen des brevets

(19)

(11) Veröffentlichungsnummer: **0 257 305**
**A2**

(12) **EUROPÄISCHE PATENTANMELDUNG**

(21) Anmeldenummer: **87110647.2**

(22) Anmeldetag: **23.07.87**

(51) Int. Cl.⁴: **G01D 5/48**

Ein Antrag gemäss Regel 88 EPÜ auf Berichtigung betreffend der Zeichnungen liegt vor. Über diesen Antrag wird im Laufe des Verfahrens vor der Prüfungsabteilung eine Entscheidung getroffen werden (Richtlinien für die Prüfung im EPA, A-V, 2.2).

(30) Priorität: **16.08.86 DE 3627850**

(43) Veröffentlichungstag der Anmeldung:
**02.03.88 Patentblatt 88/09**

(84) Benannte Vertragsstaaten:
**AT CH DE FR GB LI**

(71) Anmelder: **Leybold-Heraeus GmbH**
**Bonner Strasse 498 Postfach 51 07 60**
**D-5000 Köln 51(DE)**

(72) Erfinder: **Gröschl, Martin**
**Heinestrasse 22/24**
**A-1020 Wien(AT)**
Erfinder: **Pfersmann, Gerd**
**Heinestrasse 22/24**
**A-1020 Wien(AT)**

(74) Vertreter: **Schickedanz, Willi, Dipl.-Ing.**
**Langener Strasse 70**
**D-6050 Offenbach/Main(DE)**

(54) **Schaltungsanordnung für einen positionsempfindlichen Strahlungsdetektor.**

(57) Die Erfindung betrifft eine Schaltungsanordnung für einen positionsempfindlichen Strahlungsdetektor. Mit Hilfe dieser Schaltungsanordnung ist est möglich, ein ausschließlich von den Koordinaten x bzw. y des Auftreffpunkts einer elektromagnetischen Strahlung auf der sensitiven Oberfläche einer Lateraldiode (1) abhängiges Strom-oder Spannungssignal ($U_y$) zu erzeugen. Hierzu weist die Schaltungsanordnung Integratoren (4,5) auf, in denen Spannungen ($U_1,U_2$) gebildet werden, die dem zeitlichen Integral der Ausgangsströme ($I_1,I_2$) der Lateraldiode (1) proportional sind. Die Differenz der Spannungen ($U_1,U_2$) wird als ausschließlich koordinatenabhängiges Signal zu jenem Zeitpunkt herangezogen, zu dem der arithmetische Mittelwert dieser Spannungen ($U_1, U_2$) einen vorgewählten konstanten Wert erreicht.

FIG.1

## SCHALTUNGSANORDNUNG FÜR EINEN POSITIONSEMPFINDLICHEN STRAHLUNGSDETEKTOR

Die Erfindung betrifft eine Schaltungsanordnung für einen positionsempfindlichen Strahlungsdetektor, der beim Auftreten einer elektromagnetischen Strahlung zwei Ausgangsströme $I_1$, $I_2$ liefert, deren Amplitude von der Koordinate des Auftreffpunkts der elektromagnetischen Strahlung abhängt, und der eine Anordnung aufweist, der die Ausgangsströme $I_1$, $I_2$ zugeführt werden und die ein Signal erzeugt, das nur nach von der jeweiligen Koordinate und nicht mehr von der Intensität der auftreffenden Spannung abhängt, wobei diese Anordnung eine erste Einrichtung enthält, welcher ein Ausgangsstrom zuführbar ist und welche eine Signal erzeugt, das dem Produkt aus Ausgangsstrom und Zeit proportional ist, und wobei diese Anordnung eine zweite Einrichtung enthält, der ein Ausgangsstrom zugeführt wird und die ein Signal erzeugt, das dem Produkt aus Ausgangsstrom und Zeit proportional ist.

Auf zahlreichen Gebieten der Technik ist es erforderlich, den Auftreffpunkt einer elektromagnetischen Strahlung genau zu kennen. Beispielsweise muß der Auftreffpunkt eines Elektronenstrahls auf dem Target einer Elektronenstrahl-Verdampferquelle exakt erfaßt werden, um ihn so steuern zu können, daß auf einer bestimmten Fläche eine möglichst gleichmäßige Oberflächentemperatur und damit eine über diese Fläche konstante Aufdampfrate erzielt wird. Die rein visuelle Kontrolle ist für eine vollautomatische Steuerung ungeeignet, weshalb man Bauelemente einsetzt, die auf eine bestimmte Strahlung ansprechen. Diese Bauelemente reagieren beispielsweise auf das UV-Licht oder auf die Röntgen-Strahlen, die beim Auftreffen eines Elektronenstrahls auf einem Target entstehen. Im Gegensatz zu herkömmlichen Fotozellen, lichtabhängigen Widerständen oder dergleichen, die ihren elektrischen Zustand in Abhängigkeit von der Gesamtmenge der auftreffenden Strahlung ändern und damit nicht in der Lage sind, eine Ortskoordinate anzuzeigen, müssen die vorerwähnten Bauelemente Eigenschaften aufweisen, die eine Zuordnung zu Ortskoordinaten ermöglichen.

Derartige Bauelemente sind beispielsweise sogenannte Lateraldioden. Hierbei handelt es sich um großflächige, positionsempfindliche Halbleiter-Photodioden, die den lateralen Photoeffekt ausnutzen. Diese Photodioden werden auch als PSD (Position Sensitive Detectors) bezeichnet. Unidirektionale Lateraldioden, deren sensitive Oberfläche zu einem Teil von elektromagnetischer Strahlung getroffen wird, liefern, bei geeignet gewählter Vorspannung zwei Ausgangsströme, deren Summe proportional zur Intensität der auftreffenden Strahlung und deren Differenz proportional zur Intensität und proportional zur Positionskoordinate des Schwerpunktes der auftreffenden Strahlung ist. Die Stromdifferenz bzw. eine dazu proportionale Spannung wird als nicht normiertes Positionssignal bezeichnet. In vielen Anwendungsfällen ist jedoch die Normierung dieses Signals, d. h. die Bildung eines ausschließlich positionsproportionalen Signals erforderlich.

Um eine solche Normierung zu erzielen, sind bereits verschiedene Schaltungsanordnungen vorgeschlagen worden (vergl. Fig. 5 und 6 der europäischen Patentanmeldung 85114404.8 = Veröffentlichungs-Nr. 0 184 680). Diese Schaltungsanordnungen beruhen auf dem Grundgedanken, daß mittels einer Division der Stromsumme durch die Stromdifferenz oder umgekehrt der Einfluß der Intensität der Strahlung eliminiert wird und nur nach der Einfluß der Ortskoordinate bei der Stromdifferenz übrig bleibt. Diese Division wird mittels eines Analog-Dividierers durchgeführt, der eine der Stromdifferenz proportionale Spannung durch eine der Stromsumme proportionale Spannung dividiert.

Nachteilig ist hierbei, daß durch die Dynamik des Analog-Dividierers der maximal zulässige Schwankungsbereich der Stromsumme bzw. der Intensität der auf die Lateraldiode treffenden Strahlung begrenzt ist. Nach dem beschriebenen Prinzip arbeitende Systeme mit hoher Dynamik können nur durch Verwendung kostspieliger Präzisions-Bauelemente realisiert werden, andernfalls ist es erforderlich, den Verstärkungsfaktor der Eingangsstufen umzuschalten. Ein weiterer Nachteil der bekannten Schaltungsanordnung besteht darin, daß die erreichbare Positionsauflösung mit abnehmender Stromsumme bzw. abnehmender Strahlungsintensität sinkt.

Es ist weiterhin eine Auswerteelektronik für einen Differential-Fotodiodenaufnehmer mit wechselseitigem Umladevorgang eines Kondensators und pulsbreitenmodulierter Ausgangsspannung bekannt, bei der für den wechselseitigen Umladevorgang durch eine leuchstärkeproportionalen Ladestrom der Fotodioden nur ein Kondensator für zwei Fotoempfänger eingesetzt wird (DE-OS 35 31 378). Bei dieser Auswerteelektronik wird das Positionssignal aus dem veränderlichen Tastverhältnis einer pulsbreitenmodulierten Rechteckspannung gewonne, d. h. der durch Tiefpaßfilterung erhaltene Gleichspannungsanteil dieser Rechteckspannung stellt das Positionssignal dar.

Nachteilig ist bei dieser bekannten Auswerteelektronik, daß durch die Tiefpaßfilterung die Grenzfrequenz der Auswerteelektronik herabgesetzt wird. Außerdem hängt die Gesamtdauer eines Integrationszyklus von der Größe der beiden Ladeströme ab, weshalb dann, wenn einer der Eingangsströme sehr klein wird, die Gesamtzeit für die Meßwerterfassung sehr groß ist. Sowohl der lange Integrationszyklus als auch die Herabsetzung der Grenzfrequenz lassen die bekannte Auswerteelektronik für die Erkennung rascher Bewegungsabläufe als nicht besonders geeignet erscheinen.

Der Erfindung liegt die Aufgabe zugrunde, eine Schaltungsanordnung zu schaffen, welche die genaue Position eines auf ein strahlungsempfindliches Element auftreffenden Strahls auch dann anzeigt, wenn die Intensität dieses Strahls schwankt und wenn sich dieser Strahl schnell bewegt.

Diese Aufgabe wird dadurch gelöst, daß

a) der ersten Einrichtung nur der eine Ausgangsstrom und der zweiten Einrichtung nur der andere Ausgangsstrom zugeführt wird, daß

b) eine dritte Einrichtung für den Vergleich zweier Signale vorgesehen ist, die einen ersten Eingang aufweist, an dem ein Signal mit vorgegebenem Wert anliegt und die einen zweiten Eingang aufweist, an welchem ein Signal anliegt, das sich aus von der ersten und der zweiten Einrichtung kommenden Signalen oder Teilen hiervon zusammensetzt, daß

c) eine vierte Einrichtung vorgesehen ist, die einen ersten Eingang aufweist, dem das Ausgangssignal der ersten Einrichtung zugeführt ist und die einen zweiten Eingang aufweist, dem das Ausgangssignal der zweiten Einrichtung zugeführt ist und welche die Differenz zwischen den beiden Ausgangssignalen bildet, und daß

d) eine fünfte Einrichtung vorgesehen ist, welche das Ausgangssignal der vierten Einrichtung zu dem Zeitpunkt abspeichert, in dem die beiden Eingangssignale der dritten Einrichtung gleich groß sind.

Der mit der Erfindung erzielte Vorteil besteht insbesondere darin, daß ein Analog-Dividierer entfallen kann und die Positionsauflösung weitgehend von der Strahlungsintensität unabhängig ist, da die für die Messung relevante Spannungsdifferenz der Ausgangsspannung am Ausgang der Einrichtungen, denen die Ausgangssignale das strahlungsempfindlichen Elements zugeführt werden, unabhängig von der Strahlungsintensität ist. Außerdem weist die erfindungsgemäße Schaltungsanordnung eine hohe Empfindlichkeit bzw. eine niedrige Ansprechschwelle auf. Da die Integrationszeit nur durch die Summe der beiden Ströme bestimmt wird und völlig unabhängig von deren Größe ist, ist diese Zeit sehr klein, was eine erhöhte Schnelligkeit zur Folge hat. Ferner benötigt die erfindungsgemäße Schaltungsanordnung keinen Umschalter, der von einer Integrationseinrichtung zur anderen umschaltet.

Ein Ausführungsbeispiel der Erfindung ist in der Zeichnung dargestellt und wird im folgenden näher beschrieben. Es zeigen:

Fig. 1 eine Schaltungsanordnung für die Anzeige einer y-Koordinate, die auch für die Anzeige einer x-Koordinate verwendbar ist;

Fig. 2 eine Schaltungsanordnung mit Vorverstärker für die Anzeige einer y-Koordinate, die auch für die Anzeige der x-Koordinate verwendbar ist.

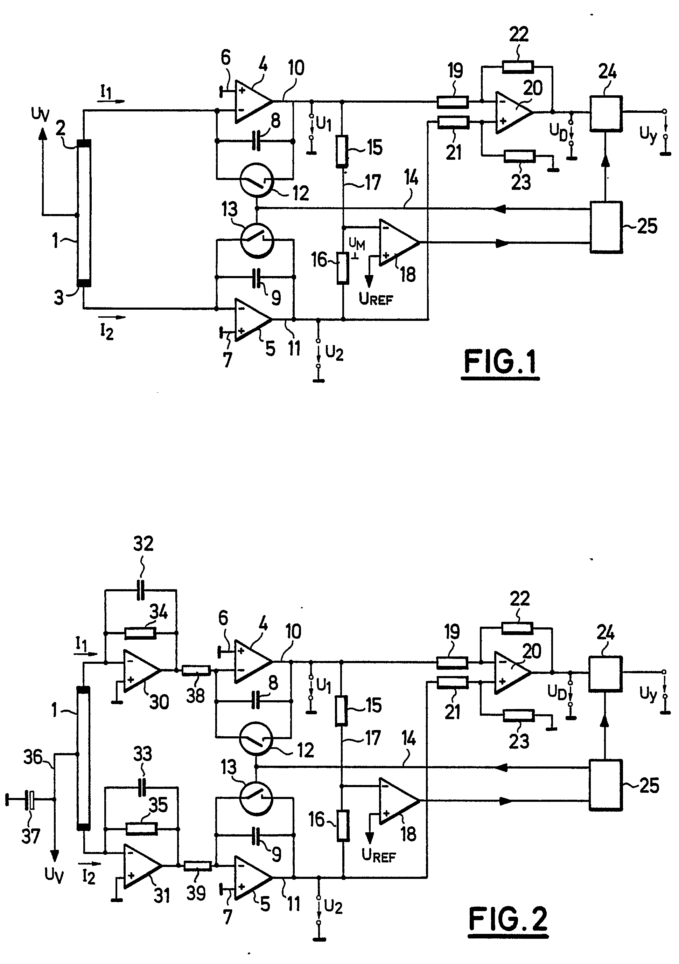

In der Fig. 1 ist eine unidirektionale Lateraldiode 1 dargestellt, die mit einer Vorspannung $U_v$ versehen ist und zwei Anschlüsse 2,3 aufweist. Von diesen Anschlüssen 2,3 führen Leitungen auf den negativen Eingang jeweils eines Operationsverstärkers 4,5 dessen positiver Eingang 6,7 an Masse liegt. Der Strom, der von dem Anschluß 2 der Lateraldiode zu dem negativen Eingang des Operationsverstärkers 4 fließt, ist mit $I_1$ bezeichnet, während der Strom, der von dem Anschluß 3 der Lateraldiode 1 zu dem negativen Eingang des Operationsverstärkers 5 fließt, mit $I_2$ bezeichnet ist. Der negative Eingang jedes der beiden Operationsverstärkers 4,5 ist über jeweils einen Kondensator 8,9 mit dem jeweiligen Ausgang 10,11 des zugeordneten Operationsverstärkers 4 bzw. 5 verbunden. Parallel zu dem Kondensator 8,9 ist ein steuerbarer Schalter 12,13 vorgesehen, der über eine Leitung 14 angesteuert werden kann. Die Ausgänge 10,11 der Operationsverstärker 4,5 sind über zwei in Reihe geschaltete Widerstände 15,16 miteinander verbunden. Von der Verbindungsleitung 17 zwischen beiden Widerständen 15,16 führt eine Verbindungsleitung an einen ersten Eingang eines Operationsverstärkers 18, an dessen zweitem Eingang eine Referenzspannung $U_{REF}$ liegt.

Der Ausgang des Operationsverstärkers 4 ist über einen Widerstand 19 mit dem negativen Eingang eines weiteren Operationsverstärkers 20 verbunden, während der Ausgang des Operationsverstärkers 5 über einen Widerstand 21 an dem positiven Eingang dieses Verstärkers 20 liegt. Der Ausgang des Operationsverstärkers 20 ist über einen Widerstand 22 mit dem negativen Eingang dieses Verstärkers 20 verbunden, während der positive Eingang dieses Verstärkers 20 über eine Widerstand 23 an Masse liegt. Von dem Ausgang des Operationsverstärkers 20 führt außerdem eine Verbindung auf eine Sample-and-Hold-Schaltung 24, an deren Ausgang eine Spannung $U_y$ ansteht. Diese Sample-and-Hold-Schaltung 24 wird von einer Steuereinrichtung 25 angesteuert, die außerdem Signale von dem Operationsverstärker 18 erhält und Signale auf die Schalter 12, 13 abgibt. Die Operationsverstärker 4,5 bilden zusammen mit den Kondensatoren 8,9 Integratorstufen, in denen die von der unidirektionalen Lateraldiode 1 gelieferten Ströme $I_1$ und $I_2$ integriert werden. Derartige Inte-

gratorstufen können beispielsweise mit Operationsverstärkern gebildet werden, die von Burr Brown unter der Bezeichnung OPA 356 vertrieben werden. Für die Ausgangsspannungen $U_1$ bzw. $U_2$ der Integratoren gilt:

$$U_1 = k\, I_1\, t \quad (1)$$
$$U_2 = k\, I_2\, t \quad (2)$$

Hierbei bedeutet t die Integrationszeit, während k für einen Proportionalitätsfaktor steht. Aus den Gleichungen (1) und (2) folgt

$$U_1 - U_2 = k\, I_1\, t - k\, I_2\, t = kt\, (I_1 - I_2) \quad (3)$$
$$U_1 + U_2 = k\, I_1\, t + k\, I_2\, t = kt\, (I_1 + I_2) \quad (4)$$

Der Proportionalitätsfaktor k ist dabei für beide Integratoren gleich angenommen.

Der Operationsverstärker 18 stellt einen Komparator dar, wie er beispielsweise mit einem von Burr Brown vertriebenen Operationsverstärker unter der Bezeichnung OPA 37 realisiert werden kann.

Dieser Komparator vergleicht die Referenzspannung, die an seinem einen Eingang ansteht, mit der Spannung $U_M$, die an seinem anderen Eingang ansteht. Bei dieser letztgenannten Spannung $U_M$ handelt es sich um den arithmetischen Mittelwert der Ausgangsspannungen $U_1$ und $U_2$ der Integratoren 4,8 bzw. 5,9. Es gilt:

$$U_M = (U_1 + U_2)/2 \quad (5)$$

Erreicht die Spannung $U_M$ den Wert $U_{REF}$, so löst der Komparator 18 folgenden Funktionsablauf aus.

Der Komparator 18 steuert die Steuerungseinheit 25 an, die ihrerseits die Sample-and-Hold-Schaltung 24 aktiviert, welche den Spannungswert $U_D$ am Ausgang des Operationsverstärkers 20 übernimmt. Bei dieser Spannung $U_D$ handelt es sich um die Differenz zwischen $U_1$ und $U_2$, denn der Operationsverstärker 20 wirkt als Subtrahierverstärker. Eine Sample-and-Hold-Schaltung der beschriebenen Art wird beispielsweise von Burr Brown unter der Bezeichnung SHC 298 vertrieben. Sodann werden die Integrationskondensatoren 8 und 9 durch Schließen der Schalter 12 bzw. 13 entladen, wodurch die Ausgangsspannungen $U_1$ und $U_2$ den Wert 0 Volt annehmen. Die Schalter 12 bzw. 13 werden beispielsweise als elektronische Schalter von National Semiconductors unter der Bezeichnung CD 4066 vertrieben. Durch anschließendes Öffnen der Schalter 12,13 wird ein neuer Integrationszyklus eingeleitet.

Wesentlich ist hierbei, daß die Messung bzw. Speicherung der momentanen Differenzspannung $U_D$ immer zu jenem Zeitpunkt erfolgt, zu dem für die Summe der Spannungen $U_1$ und $U_2$ gilt:

$$U_1 + U_2 = k'\, U_{REF} = \text{konstant} \quad (6)$$

$U_{REF}$ bedeutet eine konstante, geeignet gewählte Spannung, während k' für einen Proportionalitätsfaktor steht. Im vorliegenden Beispiel ergibt sich aus den Gleichungen (5) und (6) k' zu 2, denn aus

$$(U_1 + U_2)/2 = U_M \text{ bzw. } U_1 + U_2 = k'\, U_{REF} \text{ mit } U_M = U_{REF}.$$

folgt durch Koeffizientenvergleich k' = 2.
Für die am Ausgang der Sample-and-Hold-Schaltung 24 anliegende Spannung $U_y$ gilt mit den Gleichungen (3),(4),(5) und (6)

$$U_y = k'\, U_{REF}\, (I_1 - I_2)/(I_1 + I_2) \quad (8)$$

Dies ergibt sich aus $U_y = U_1 - U_2 = (I_1 - I_2)\, kt$, wobei aus der Gleichung (4) für

$$k \cdot t = \frac{U_1 + U_2}{I_1 + I_2}$$

gilt. Setzt man diesen Wert für kt bei $U_y$ ein, so erhält man

$$U_y = \frac{(I_1 - I_2)(U_1 + U_2)}{I_1 + I_2}$$

Da aber $U_1 + U_2 = k'\, U_{REF}$ ist, gilt

$$U_y = k'\, U_{REF} \cdot \frac{I_1 - I_2}{I_1 + I_2}$$

Aus der Gleichung (8) ist ersichtlich, daß die Spannung $U_y$ eine Größe darstellt, die nur noch von der Koordinate und nicht mehr von der Größe der Summe der Ströme $I_1$ und $I_2$ abhängt. Im vorliegenden Beispiel ist sie der y-Koordinate zugeordnet.

Die Wahl von $U_{REF}$ richtet sich nach der Größe der Kondensatoren 8 bzw. 9. Es gilt der Zusammenhang

$$t = k'\, C_{8,9}\, U_{REF}/(I_1 + I_2)$$

wobei $C_{8,9}$ die Kapazität der Kondensatoren 8,9 bezeichnet. De Größe von UREF beeinflußt, innerhalb technischer Grenzen, nicht die von der Schaltungsanordnung geleistete Normierung des Positionssignals.

In der Fig. 2 ist eine Schaltungsanordnung gezeigt, die der Schaltungsanordnung gemäß Fig. 1 weitgehend entspricht. Im Gegensatz zu jener weist sie vor den Integratoren 4,8 bzw. 5,9 Vorverstärker auf, die aus den Operationsverstärkern 30,31 bestehen, in deren Rückführungszweig eine Parallelschaltung aus Kondensator 32,33 und Widerstand 34,35 vorgesehen ist. Diese Vorverstärker verstärken die Ströme $I_1,I_2$, die von der Lateraldiode 1 kommen. Die Leitung 36, an welcher die Vorspannung $U_v$ anliegt, ist an einen Kondensator 37 angeschlossen. Zwischen den Eingängen der Operationsverstärker 4 bzw. 5 und den Ausgängen der Verstärker 30 bzw. 31 sind Widerstände 38,39 vorgesehen.

Es versteht sich, daß die Schaltungsanordnungen gemäß Fig. 1 und 2, obwohl sie nur für die Anzeige der y-Koordinate dargestellt sind, in entsprechender Weise auch für die Anzeige der x-Koordinate vorgesehen werden können.

Mit zwei Schaltungsanordnungen gemäß Fig. 1 oder 2 lassen sich die x,y-Positionen eines Strahls innerhalb eines x,y-Feldes erfassen, wenn man beispielsweise eine Anordnung gemäß Fig. 2 der EP-A-0184680 wählt.

## Ansprüche

1. Schaltungsanordnung für einen positionsempfindlichen Strahlungsdetektor, der beim Auftreten einer elektromagnetischen Strahlung zwei Ausgangsströme $I_1$, $I_2$ liefert, deren Amplitude von der Koordinate des Auftreffpunkts der elektromagnetischen Strahlung abhängt, und der eine Anordnung aufweist, der die Ausgangsströme $I_1$, $I_2$ zugeführt werden und die ein Signal erzeugt, das nur noch von der jeweiligen Koordinate und nicht mehr von der Intensität der auftreffenden Strahlung abhängt, wobei diese Anordnung eine erste Einrichtung enthält, welcher ein Ausgangsstrom zuführbar ist und welche ein Signal erzeugt, das dem Produkt aus Ausgangsstrom und Zeit proportional ist, und wobei diese Anordnung eine zweite Einrichtung enthält, der ein Ausgangsstrom zugeführt wird und die ein Signal erzeugt, das dem Produkt aus Ausgangsstrom und Zeit proportional ist, **dadurch gekennzeichnet,** daß

a) der ersten Einrichtung (4, 8) nur der eine Ausgangsstrom ($I_1$) und der zweiten Einrichtung (5, 9) nur der andere Ausgangsstrom ($I_2$) zugeführt wird, daß

b) eine dritte Einrichtung (18) für den Vergleich zweier Signale vorgesehen ist, die einen ersten Eingang aufweist, an dem ein Signal mit vorgegebenem Wert ($U_{REF}$) anliegt und die einen zweiten Eingang aufweist, an welchem ein Signal ($U_M$) anliegt, das sich aus von der ersten und der zweiten Einrichtung (4, 8; 5, 9) kommenden Signalen ($U_1$, $U_2$) oder Teilen hiervon zusammensetzt, daß

c) eine vierte Einrichtung (20) vorgesehen ist, die einen ersten Eingang aufweist, dem das Ausgangssignal ($U_1$) der ersten Einrichtung (4, 8) zugeführt ist und die einen zweiten Eingang aufweist, dem das Ausgangssignal ($U_2$) der zweiten Einrichtung (5, 9) zugeführt ist und welche die Differenz zwischen den beiden Ausgangssignalen ($U_1 - U_2$) bildet, und daß

d) eine fünfte Einrichtung (24) vorgesehen ist, welche das Ausgangssignal ($U_D$) der vierten Einrichtung (20) zu dem Zeitpunkt abspeichert, in dem die beiden Eingangssignale ($U_M$, $U_{REF}$) der dritten Einrichtung (18) gleich groß sind.

2. Schaltungsanordnung nach Anspruch 1, **dadurch gekennzeichnet,** daß die erste und die zweite Einrichtung (4, 8; 5, 9) Integratoren sind.

3. Schaltungsanordnung nach Anspruch 1, **dadurch gekennzeichnet,** daß die elektronische Bauelement eine Lateraldiode (1) ist.

4. Schaltungsanordnung nach Anspruch 1, **dadurch gekennzeichnet,** daß die elektronische Bauelement ein Differential-Fotodiodenaufnehmer mit zwei Fotodioden ist.

5. Schaltungsanordnung nach Anspruch 2, **dadurch gekennzeichnet,** daß als Integratoren Operationsverstärker (4, 5) mit Kondensatoren (8, 9) in der Rückführung vorgesehen sind, wobei diese Kondensatoren (8, 9) über parallelgeschaltete Schalter (12, 13) kurzschließbar sind.

6. Schaltungsanordnung nach Anspruch 5, **dadurch gekennzeichnet,** daß die Schalter (12, 13) aufgrund eines Befehls einer sechsten Einrichtung (25) geschlossen werden, die mit dem Ausgang der dritten Einrichtung (18) verbunden ist.

7. Schaltungsanordnung nach den Ansprüchen 1 und 6, **dadurch gekennzeichnet,** daß die sechste Einrichtung (25) mit der fünften Einrichtung (24) in Verbindung steht und diese aktiviert, wenn am Ausgang der dritten Einrichtung (18) ein Signal erscheint.

8. Schaltungsanordnung nach Anspruch 1, **dadurch gekennzeichnet,** daß die fünfte Einrichtung (24) eine Sample-and-Hold-Schaltung ist.

9. Schaltungsanordnung nach Anspruch 1, **dadurch gekennzeichnet,** daß sie zweifach vorgesehen ist, wobei die eine Schaltungsanordnung die x-Koordinate und die andere Schaltungsanordnung die y-Koordinate bestimmt.

10. Schaltungsanordnung' nach Anspruch 1, **dadurch gekennzeichnet,** daß die Proportionalitätsfaktoren k der ersten und der zweiten Einrichtung (4, 8; 5, 9) identisch sind.

11. Schaltungsanordnung nach den Ansprüchen 1 und 3, **dadurch gekennzeichnet,** daß die Ausgangsströme ($I_1$, $I_2$), die der Strahlungsdetektor (1) beim Auftreffen einer elektromagnetischen Strahlung pro Achsenrichtung liefert, in der die Positionsempfindlichkeit des Detektors (1) gegeben ist, hinsichtlich ihrer Amplituden von der Koordinaten des Auftreffpunkts der elektromagnetischen Strahlung in der jeweiligen Richtung abhängen.

**FIG.1**

**FIG.2**

87110647.2

**FIG.1**

**FIG.2**

DIPL.-ING. WILLI SCHICKEDANZ

·PATENTANWALT

EUROPEAN PATENT ATTORNEY

ZUGELASSENER VERTRETER BEIM EUROPÄISCHEN PATENTAMT
MANDATAIRE AGRÉÉ PRÈS L'OFFICE EUROPÉEN DES BREVETS

LANGENER STRASSE 70

D-6050 OFFENBACH

GERMANY, Fed. Rep.

Patentanwalt Schickedanz · Langener Str. 70 · D-6050 Offenbach

An das

Europäische Patentamt

Erhardtstraße 27

8000 München 2

| | |
|---|---|
| Telefon: Phone: Téléphone: | (069) Ø 89 23 17 |
| Telegramm-Adresse Cable address: Télégramme: | „SICPAT" |
| Telefax (Gruppe 3): Telecopier (group 3): Télécopieur (groupe 3): | (069) 89 77 87 |
| Postgirokonto: P.O. Giro Account: Chèques Posteaux: | Frankfurt No. 2825 90-606 |
| Bankkonto: Bankers: Compte en Banque: | Deutsche Bank AG Offenbach No. 147/1325 |

| Ihr Zeichen · Your ref. | Ihre Nachricht vom · Your letter of | Mein Zeichen · My ref. | Datum · Date |
|---|---|---|---|
| | | P 360-LH/EU | 10. November 1987 |

Betreff · Re:

Europäische Patentanmeldung 87110647.2

Leybold-Heraeus GmbH

EPA E-U-OEB
DG 1
Reçu:
17 -11- 1987
03     ANL ZEICHN.

In den Zeichnungen zu der obigen Patentanmeldung wurden zwei offensichtliche Unrichtigkeiten festgestellt:

1. In Fig. 1 und 2 muß es heißen "$U_D$" statt "$U_0$" (s. Beschreibung, z. B. Seite 7, Zeilen 18, 19, 31).

2. In Fig. 2 waren die in der Beschreibung auf Seite 9, Zeile 14 erwähnten Widerstände mit den Bezugszahlen 38 und 39 nicht eingezeichnet.

Beiliegend werden neue vorschriftsmäßige Zeichnungen in dreifacher Ausfertigung mit dem Antrag überreicht, die ursprünglich eingereichten Zeichnungen durch die beigefügten Zeichnungen zu ersetzen.

W. Schickedanz

(European Patent Attorney)

Anlage

Fig. 1 und 2, 3fach

Für telefonische Auskünfte wird keine Haftung übernommen.